# EUROPEAN PATENT SPECIFICATION

(11) **EP 3 675 139 B1**
(45) Date of publication and mention of the grant of the patent: **03.09.2025**
(21) Application number: 18848779.7
(22) Date of filing: 31.07.2018
(51) Int. Cl.: H01B 1/22, C08K 3/04, H01B 5/14, H01B 13/00, H05K 3/12, F21V 23/04, C08L 67/00, C08L 75/04

(54) **ELECTRICALLY CONDUCTIVE PASTE, THREE-DIMENSIONAL PRINTED CIRCUIT, TOUCH SENSOR, AND METHODS FOR PRODUCING THE SAME**
ELEKTRISCH LEITFÄHIGE PASTE, DREIDIMENSIONALE PLATINE, BERÜHRUNGSSENSOR UND VERFAHREN ZUR HERSTELLUNG DIESER PRODUKTE
PÂTE CONDUCTRICE ELECTRIQUE, CIRCUIT IMPRIMÉ TRIDIMENSIONNEL, CAPTEUR TACTILE ET PROCÉDÉS POUR PRODUIRE CES PRODUITS

(30) Priority: 24.08.2017 JP 2017161252
(43) Date of publication of application: 01.07.2020
(73) Proprietor: TOYOBO MC Corporation, Osaka 530-0001 (JP)
(72) Inventor: TAGA, Keiko, Otsu-shi Shiga 520-0292 (JP)
(74) Representative: Müller-Boré & Partner Patentanwälte PartG mbB
(86) International application number: PCT/JP2018/028585
(87) International publication number: WO 2019/039209

(56) References cited:
- WO-A1-2011/046076
- JP-A- 2001 319 524
- JP-A- 2001 319 524
- JP-A- 2008 262 981
- JP-A- 2014 510 319
- JP-A- 2014 510 319
- JP-A- 2018 041 692

## Description

### Technical Field of the Invention

The present invention relates to a three-dimensional printed circuit having a wire formed from an electrically conductive paste and a touch sensor having a wire formed from an electrically conductive paste. More particularly, it relates to an electrically conductive paste for molding processing which is used for forming wires for circuit sheets in three-dimensional structure, curved printed-wiring boards and three-dimensional circuit parts being used for display panels and operation panels for domestic electric appliances, for mobile phones, for mobile information instruments, and for switch parts of car interior parts, etc. The present invention particularly relates to an electrically conductive paste which can prevent disconnection of circuit pattern by thermal stretching during molding.

### Background Art

In order to improve design and operation of electric appliances, there has been a brisk development for making operation surfaces into a three-dimensional structure (a steric appearance) in recent years. There has been an increasing demand for printed circuit boards and touch sensors having a three-dimensional structure. As to a method for producing a circuit sheet or a three-dimensional molded product having such electric circuits, there has been known a method wherein a circuit pattern is formed on a substrate made of synthetic resin and is processed into a three-dimensional shape by thermal molding such as vacuum molding or press molding. Patent Document 1 proposes a method for producing an electrically conductive laminate wherein an electrically conductive layer is formed using a silver salt method or a carbon nanotube. The resulting laminate exhibits a good resistance-changing rate under 20% stretch rate when the laminate is subjected to the thermal stretching together with the substrate by a tensile test. However, in the electrically conductive layer as such, there is a problem that bigger thermal deformation is resulted when the press molding or the vacuum molding is conducted whereupon disconnection is generated in the circuit pattern.

Patent Document 2 proposes a method wherein wires are formed by printing an electrically conductive paste on a resin substrate and the substrate is subjected to thermal molding whereupon a three-dimensional shape is obtained. However, due to use of silver powder in flakes in the proposed electrically conductive paste, there may be a problem of disconnection or detachment of wires due to the thermal stretching, in a case of forming into a recently-demanded 3D shape such as dome shape or into more complicated shape.

Patent Document 3 discloses a circuit material using a conductive paste having improved heat resistance, moisture resistance, thermal shock resistance and bending resistance and showing improved adhesion to an organic film, a metal substrate or a glass substrate.

Patent Document 4 discloses a molding method comprising patterning one or more electrical layers on a substrate; shaping the patterned substrate into a 3-dimensional contour, wherein the contour including a significant change in gradient in or adjacent to one or more sensing areas of the electrical layer-, and over-molding the shaped substrate.

Patent Document 5 discloses an electrically conductive paste which can be used for the formation of an electrically conductive thin film that has significantly improved adhesion to a substrate having a transparent electrically conductive layer or the like and can impart high reliability and high electrical conductivity to the substrate.

### Prior Art Documents

### Patent Documents

Patent Document 1: WO 2017/081948
Patent Document 2: Japanese Patent Application Laid-Open (JP-A) No. 2014-531490
Patent Document 3: JP 2001 319524 A
Patent Document 4: JP 2014 510319 A
Patent Document 5: WO 2011/046076 A1

### Disclosure of the Invention

### Problem that the Invention is to Solve

In view of the above circumstances, a problem which is to be solved by the present invention is to provide an electrically conductive paste for molding processing used for forming a wire in a three-dimensional printed circuit and a touch sensor which does not cause any disconnection of the circuit pattern by the thermal stretching even in such a step wherein a laminate having the circuit pattern is subjected to molding by heat and pressure.

### Means for Solving the Problem

The inventor of the present invention has solved the above problem and now provides a three-dimensional printed circuit having a wire formed from a paste which does not cause any disconnection of the circuit pattern even in the thermal stretching during molding and which exhibits excellent tight adhesion to the substrate, a method for producing the three-dimensional printed circuit, and a touch sensor having a wire formed from the paste and a method for producing the touch sensor.

Thus, the present invention is defined in the appended set of claims.

### Advantages of the Invention

According to the present invention, it is now possible to provide a three-dimensional printed circuit and a touch sensor, which have a wire formed from an electrically conductive paste for molding processing which does not cause any disconnection of the circuit pattern even in the thermal stretching during molding and which exhibits excellent tight adhesion to the substrate. The electrically conductive paste for molding processing used in the present invention can be advantageously used particularly in such a case wherein a thermoplastic resin having transparency such as PET, PEN, polycarbonate, polymethacrylate and polystyrene is used as the substrate. Also, the electrically conductive paste for molding processing used in the present invention can follow even the processing with big deformation wherein the deformation rate is more than 100%, preferred to be more than 120%, and further preferred to be more than 135%, without any disconnection.

### Best Mode for Carrying Out the Invention

As to the electrically conductive powder to be used in the present invention, silver powder is used in view of electrical conductivity, stability, and cost. As to a shape of the silver powder, there are exemplified flakes (scales), spheres (including a formless shape), plates, dendrites, and a shape wherein primary particles in spheric or formless shape are aggregated in a three-dimensional manner (aggregated silver particles). In the present invention, by using the silver particles in an aggregated type (aggregated silver particles) among these, disconnection does not happen even after molding into a three-dimensional shape whereby the electrical conductivity can be maintained. When the silver flakes are used as the silver powder, the particles are apt to be oriented due to their big aspect ratio whereby stress is apt to be concentrated upon stretching and, as a result, the disconnection is apt to happen. When the spherical silver having small aspect ratio is used, although ductility upon molding is good as compared with the case of the silver flakes, the disconnection may happen particularly under a severe stretching condition such as stretching in a concave part. This is likely to be due to the following fact. That is, since the spherical silver is uniformly dispersed, it follows the resin during the stretching and is uniformly stretched whereby contact of the particles with each other cannot be secured. However, when an amount of the electrically conductive filler is increased for securing the contact, flexibility of a coat upon stretching cannot be secured whereupon the disconnection happens.

On the contrary, the inventor of the present invention has found that, when the aggregated silver particles are used, the disconnection does not happen in the circuit pattern even after the molding whereby the electrical conductivity can be secured. The aggregated silver particles used in the present invention are silver particles in such a shape wherein primary particles having a particle diameter of 0.1 to 3 µm are aggregated in a three-dimensional manner. When the circuit pattern after printing, curing, and molding of the electrically conductive paste for molding processing in the present invention was observed under a scanning electron microscope, the silver powder in the stretched part is aligned in a belt shape in an aggregated state. It is likely that the silver powder which was once dispersed as a paste and uniformly made into a coat is flown by heating and aggregated once again by a stress upon stretching, whereby a part wherein the resin is dense and a part wherein the silver powder is dense are formed whereby the electrical conductivity can be secured. This phenomenon was not noted in the flaky silver and the spherical silver but was specific in the aggregated silver particles. In the meantime, this phenomenon was not noted in such a case wherein molding-processing was not done and only curing temperature was increased. Thus, it has been found that the use of the aggregated silver particles in the molding processing is effective.

The aggregated silver particles may be used solely. Alternatively, plural silver powders may be combined. When plural ones are used, silver particles in any of the following shapes may be combined within such an extent that the effect of the present invention is not deteriorated thereby: flakes, spheres (including formless shape), plates, dendrites, and a shape wherein primary particles in spheric or formless shape are aggregated in a three-dimensional manner. When the aggregated silver particles are used together with the silver powder in flakes, spheres, etc., it is preferred in view of moldability that a compounding amount of the silver powder in flakes, spheres, etc., is 20% by mass or less to a total amount of the silver powder.

The tap density of the aggregated silver particles is 2 to 5 g/cm³, and preferred to be 2.1 to 4.3 g/cm³. When it is out of this range, the disconnection is apt to happen due to the stretch upon molding.

Further, the specific surface area of the aggregated silver particles is preferred to be 0.5 to 2.0 m²/g, and more preferred to be 0.8 to 1.6 m²/g. When it is less than 0.5 m²/g, the electrical conductivity is hardly secured while, when it is more than 2.0 m²/g, the disconnection is apt to happen due to the stretch upon molding.

As to the average particle diameter of the silver powder, D50 is usually used. D50 is an average particle diameter based on a volume determined by a laser diffraction method. In the laser diffraction scattering method, the particle diameter is determined by utilizing the fact that a scattering diffraction pattern of light relates to a size of the particle and that strength of a scattered light is proportional to particle numbers. However, when each particle is not individually dispersed, a measured value is apt to be deviated. Particularly, in the case of aggregated silver particles, the primary particles exist in an aggregated state whereby, even in the silver powder in a similar shape, the D50 may be in a different value.

Under such circumstance, the inventor of the present invention conducted a screen printing after preparation of the electrically conductive paste, observed a coat thereof under a scanning electron microscope, and measured the particle diameters of arbitrary 100 particles, each of which can be judged as one particle, whereupon the average particle diameter of the primary particle was determined.

The average particle diameter determined by this method is 0.1 to 3 µm, preferred to be 0.15 to 2 µm, and more preferred to be 0.2 to 1 µm. When the particle diameter is less than the predetermined range, an amount of the filler increases whereby the disconnection is apt to happen upon the molding while, when it is more than the predetermined range, a conductive path is hardly formed whereby the disconnection is similarly apt to happen upon the molding.

The resin used in the present invention is required to contain a resin having flexibility and three-dimensional molding property as a main component. Accordingly, the resin used in the present invention is required to have glass transition temperature of 45°C or lower. When the glass transition temperature is higher than 80°C, the disconnection may happen upon stretching. As to the resin having the glass transition temperature of 45°C or lower, there may be used polyurethane resin, polyester urethane resin, polyester resin, polyether urethane resin, polycarbonate urethane resin, copolymer of vinyl chloride with vinyl acetate, epoxy resin, phenoxy resin, phenol resin, polyvinylacetal resin, acrylic resin, polyacrylonitrile-type resin, polybutadiene-type resin, hydrogenated polybutadiene-type resin, modified celluloses such as nitrocellulose, cellulose acetate butyrate (CAB), cellulose acetate propionate (CAP), and polyamideimide resin. Each of those resins may be used solely or two or more thereof may be used jointly. Although a lower limit of the glass transition temperature is not particularly limited, it is preferred to be -30°C or higher, and more preferred to be -20°C or higher. When the glass transition temperature is lower than -30°C, the tight adhesion to the substrate may lower in a reliability test under high temperature and high humidity.

Among those resins, preferred ones are polyester resin, polyester urethane resin, epoxy resin, phenoxy resin and polyvinylacetal resin in view of the tight adhesion to the substrate.

The number-average molecular weight of the resin is preferred to be 5,000 or more and 40,000 or less. When the number-average molecular weight is less than 5,000, cohesive force lowers whereby electrical conductivity at an initial stage may lower. On the contrary, when the number-average molecular weight is more than 40,000, viscosity of a resin solution may become high. Accordingly, it is necessary to increase an amount of solvent so as to achieve the viscosity suitable for printing whereby a film thickness of the coat upon printing becomes thin.

The electrically conductive paste used in the present invention is compounded with a curing agent which can react with the resin. Although the type of the curing agent which can be used in the present invention is not limited, an isocyanate compound and an epoxy compound are particularly preferred in view of adhesive property, resistance to bending, curing property, etc. As to the above isocyanate compound, a compound wherein isocyanate group is blocked exhibits improved storage stability and thus is more preferred. As to the curing agent other than the isocyanate compound and the epoxy compound, there are exemplified known compounds such as methylated melamine, butylated melamine, benzoguanamine, amino resin (such as urea resin), acid anhydride, imidazoles, epoxy resin and phenol resin. The curing agent may also be used together with a known catalyst or promoter which may be selected depending upon its type. A compounding amount of the curing agent is preferred to be 0.5 to 50 part (s) by mass, more preferred to be 1 to 30 part(s) by mass, and further preferred to be 2 to 20 part(s) by mass to 100 parts by mass of the binder resin (A) .

As to the isocyanate compound which can be compounded with the electrically conductive paste for molding processing of the present invention, there are exemplified aromatic or aliphatic diisocyanate, and trivalent or higher polyisocyanate. They may be any of low-molecular and high-molecular compounds. Examples thereof are an aliphatic diisocyanate (such as tetramethylene diisocyanate and hexamethylene diisocyanate); an aromatic diisocyanate (such as toluene diisocyanate, diphenylmethane diisocyanate and xylylene diisocyanate); an alicyclic diisocyanate (such as hydrogenated diphenylmethane diisocyanate, hydrogenated xylylene diisocyanate, dimer acid diisocyanate and isophorone diisocyanate) ; or a trimer of the isocyanate compound as such; and a compound containing a terminal isocyanate group prepared by a reaction of an excessive amount of the isocyanate compound as such with, for example, a low-molecular active hydrogen compound (such as ethylene glycol, propylene glycol, trimethylolpropane, glycerol, sorbitol, ethylenediamine, monoethanolamine, diethanolamine and triethanolamine) or a high-molecular active hydrogen compound (such as various types of polyester polyols, polyether polyols and polyamides). As to a blocking agent for the isocyanate group, there are exemplified phenols (such as phenol, thiophenol, methyl thiophenol, ethyl thiophenol, cresol, xylenol, resorcinol, nitrophenol and chlorophenol); oximes (such as acetoxime, methylethyl ketoxime and cyclohexanone oxime); alcohols (such as methanol, ethanol, propanol and butanol) ; halogen-substituted alcohols (such as ethylene chlorohydrine and 1,3-dichloro-2-propanol); tertiary alcohols (such as t-butanol and t-pentanol); and lactams (such as ε-caprolactam, δ-valerolactam, γ-bytyrolactam and β-propiolactam). Besides those, there are also exemplified aromatic amines, imides, acetylacetone, acetacetate, ethyl malonate and other active methylene compounds as well as mercaptans, imines, imidazoles, ureas, diaryl compounds, and sodium bisulfite. Among them, oximes, imidazoles and amines are particularly preferred in view of curing property.

As to the epoxy compound which can be compounded with the electrically conductive paste for molding processing used in the present invention, there are exemplified aromatic or aliphatic diglycidyl ether, and trivalent or higher polyglycidyl ether. They may be any of low-molecular and high-molecular compounds. For example, there are exemplified glycerol polyglycidyl ether, trimethylolpropane polyglycidyl ether, pentaerythritol polyglycidyl ether, diglycerol polyglycidyl ether, polyglycerol polyglycidyl ether, sorbitol polyglycidyl ether, neopentyl glycol diglycidyl ether, 1,6-hexanediol diglycidyl ether, hydrogenated bisphenol-type diglycidyl ether, ethylene glycol diglycidyl ether, diethylene glycol diglycidyl ether, polyethylene glycol diglycidyl ether and polypropylene glycol diglycidyl ether.

As to the electrically conductive powder, it is possible to compound, in addition to the aggregated silver particles, with a carbon-type filler such as carbon black and graphite powder and/or metal such as copper, gold, platinum, palladium, nickel, aluminum and zinc, alloy of metal selected therefrom, as well as a filler coated with metal selected therefrom.

It is also possible to use an inorganic filler such as silica, talc, mica or barium sulfate in a mixed manner. In view of electrical conductivity, environmental characteristics such as resistance to humidity and cost, it is preferred to compound carbon black and silica in an amount of 20% by mass or less to the total electrically conductive powder. The compounding amount is further preferred to be 5% by mass or less and 0.1% by mass or more.

In the electrically conductive paste used in the present invention, its F value is preferred to be 70 to 90%, and more preferred to be 80 to 85%. F value is a value representing an amount in part (s) by mass of the electrically conductive powder contained in 100 parts by mass of a total solid in the paste. Thus, F value is expressed by "[(Electrically conductive powder in part (s) by mass) / (Solid in part (s) by mass)] × 100". The term reading "Solid in part (s) by mass" hereinabove covers all of the electrically conductive powder (other than the solvent), other filler, resin, and other curing agent and additive. When F value is less than 70%, electrical conductivity tends to worsen. In addition, adhesion and pencil hardness may also tend to lower. When F value is more than 90%, there is a tendency that an amount of the binder resin becomes insufficient whereby the disconnection happens on the coat upon molding. When a filler is compounded in addition to the aggregated silver particles, an amount of the filler is preferred to be 0 to 5% by mass to the aggregated silver particles. When it is more than 5% by mass, the conductive path of the aggregated silver particles may be inhibited and electrical conductivity may become bad.

As to the solvent (B) used in the present invention, there is no limitation for its type. Examples thereof are ester type, ketone type, ether ester type, alcohol type, ether type, terpene type, and hydrocarbon type. Among those, preferred ones are high-boiling solvents suitable for screen printing such as ethyl carbitol acetate (ECA), butyl cellosolve acetate, butyl carbitol acetate, isophorone, benzyl alcohol, terpineol, γ-butyrolactone and dipropylene glycol monomethyl ether (DPM) . In view of solubility for resin and printing property, preferred ones are ethyl carbitol acetate, butyl cellosolve acetate and butyl carbitol acetate.

The electrically conductive paste for molding processing used in the present invention may be also compounded with thixotropic agent, antifoaming agent, flame retarding agent, tackifier, hydrolysis-preventing agent, leveling agent, plasticizer, antioxidant, ultraviolet absorber, flame retarding agent, pigment, dye or dispersing agent. It is also possible to appropriately compound carbodiimide and epoxy as a suppressor for resin decomposition. Each of them may be used either solely or jointly.

In the electrically conductive composition used in the present invention, a coat (which is to become a circuit pattern) is formed on a resin substrate (which can be subjected to a three-dimensional molding) by a simple method such as screen printing, and then an organic solvent contained in the coat is evaporated to dry the coat whereby an electrically conductive coat can be formed. As to the resin substrate, it is possible to use a synthetic resin substrate which can be subjected to molding processing. As to the synthetic resin substrate, there are exemplified polystyrene resin, polycarbonate resin or polycarbonate/poly-butyl terephthalate alloy film, (meth) acrylic resin, polyester resin, ABS resin and polyvinyl chloride resin. In view of moldability and physical property of a molded product, preferred ones are polycarbonate resin, ABS resin and polyester resin and more preferred one is polycarbonate resin.

Although a thickness of the substrate is not particularly limited, it is preferred to be 50 to 500 µm. When the thickness is thinner than 50 µm, curl may be generated in printing of the circuit pattern or the substrate may be broken upon molding.

As to a method for printing the electrically conductive paste used in the present invention on the resin substrate, there may be used publicly known printing method such as offset printing, gravure printing and screen printing. In view of coat thickness and productivity, screen printing is preferred.

In the present invention, the electrically conductive paste is printed on the resin substrate followed by curing and the resulting print is subjected to heat press molding, vacuum molding, pressure molding or vacuum pressure molding whereby a three-dimensional printed circuit having a wire formed from the electrically conductive paste and a touch sensor having a wire formed from the electrically conductive paste can be prepared.

### Example

Hereinafter, the present invention will be illustrated by way of Examples. In the Examples, a term which simply reads "part (s)" means part (s) by mass. Each of measuring items was conducted in accordance with the method as shown below.

### (1) Number-average particle diameter of primary particles

A coat was observed in 5000 magnifications under a scanning electron microscope (SEM). The particle diameters of arbitrary 100 particles, each of which can be judged as one particle, were measured, and an average value thereof was calculated whereby the average particle diameter of the primary particles was determined.

### (2) Glass transition temperature (Tg)

A sample resin (5 mg) was placed in a sample pan made of aluminum, tightly sealed and measured using a differential scanning calorimeter (DSC) manufactured by Seiko Instruments (DSC-220) at a temperature range of from -50°C up to 200°C in a temperature-rising velocity of 20°C/minute. The glass transition temperature (Tg) was determined from a temperature at a crossing point of an extended line of a base line of not higher than the glass transition temperature with a tangent showing the maximum inclination at a transition part.

### (3) Number-average molecular weight

A sample resin was dissolved in tetrahydrofuran so as to adjust a resin concentration about 0.5% by mass. The resulting solution was filtered through a membrane filter made of polyethylene tetrafluoride having a pore size of 0.5 µm to prepare a sample for GPC measurement. A GPC measurement of the resin sample was conducted under the following conditions: tetrahydrofuran was adopted as a mobile phase; Prominence (a gel permeation chromatograph (GPC) manufacture by Shimadzu) was used; a differential refractive index detector (RI meter) was adopted as a detector; a column temperature was 30°C; and a flow rate was 1 ml/minute. The number-average molecular weight was calculated as a reduced value for standard polystyrene, and the calculation was conducted by omitting a part corresponding to a molecular weight of less than 1000. As to the GPC columns, Shodex KF-802, 804L and 806L manufactured by Showa Denko were used.

### (4) Preparation of test piece

An electrically conductive paste was applied onto a polycarbonate film of 500 µm thickness by screen printing in a pattern of 25 mm width and 200 mm length so as to make a film thickness after drying 7 to 12 µm (for the measurement of specific resistance, adhesive property and pencil hardness). This was dried under a condition of 130°C for 30 minutes using a hot air circulating oven to prepare a test piece.

### (5) Preparation of printed product for evaluating moldability

An electrically conductive paste was applied onto a substrate similar to the above (4) by screen printing in a lattice-shaped pattern of 2.5 mm intervals, and then dried to prepare a printed product for evaluating of moldability.

### (6) Specific resistance

Film thickness and sheet resistance of the test piece prepared in the above (4) were measured using a measuring device for film thickness and a measuring device for four-terminal resistance. The specific resistance was calculated therefrom. Specifically, the film thickness was measured using a Gage Stand ST-022 (manufactured by Ono Sokkisha), and the sheet resistance was measured using Milliohm Meter 4338B (manufactured by Hewlett Packard).

### (7) Adhesive property

Adhesive property was evaluated based on the test piece prepared in the above (4) by means of a cross-cut tape peeling. A number of the cut in each direction of a lattice pattern was 11, and an interval of the cut was 1 mm. One hundred boxes (10 × 10 boxes) were prepared. As to the adhesive tape, Cellophane Tape CT-12 (manufactured by Nichiban) was used. A case wherein the coat was remained in the substrate in 100% of the 100 boxes after peeling-off the tape was marked "oo". A case wherein the coat was remained in the substrate in 95 to 99% of the 100 boxes after peeling-off the tape was marked "o". A case wherein the coat was remained in the substrate in 94% or less of the 100 boxes after peeling-off the tape was marked "×".

### (8) Pencil hardness

The test piece prepared in the above (4) was placed on an SUS 304 plate in 2 mm thickness, and its pencil hardness was measured in accordance with JIS K 5600-5-4 (1999).

### (9) Stability upon storage

The electrically conductive paste was placed in a tightly-sealed container and stored at 40°C for two weeks. Viscosities thereof before and after the storage were measured at 2.5 rpm and 25°C for 3 minutes by 5 × HBDV3 (manufactured Brookfield) using a rotor CPE-52. A case wherein absolute value of a viscosity change after the storage as compared with before the storage was 10% or less was marked "oo". A case wherein absolute value of a viscosity change after the storage as compared with before the storage was more than 10% and 20% or less was marked "o". A case wherein absolute value of a viscosity change after the storage as compared with before the storage was more than 20% and 30% or less was marked "Δ". A case wherein absolute value of a viscosity change after the storage as compared with before the storage was more than 30% was marked "×".

### (10) Moldability

The printed product prepared in the above (5) was molded into a predetermined shape using a vacuum molding machine. A case wherein a change in the resistance value in a concave shape part when elongated from an initial wire length (2.5 mm) to 6 mm (+140%) was ≤500% was marked "oo". A case wherein a change in the resistance value in a concave shape part when elongated from an initial wire length (2.5 mm) to 6 mm (+140%) was 501 to 1000% was marked "o". A case wherein a change in the resistance value in a concave shape part when elongated from an initial wire length (2.5 mm) to 6 mm (+140%) was >1000% was marked "Δ". A case wherein disconnection happened was marked "×".

### <Example 1>

Silver powder 1 (697 parts), 6 parts of electrically conductive carbon black, 112 solid parts of polyester resin, 5 parts of Disperbyk 101 (manufactured by BYK Chemie Japan) as a dispersing agent and 169 parts of ethyl carbitol acetate as a solvent were compounded, well premixed and dispersed for three times using a chilled triple roll mill. The resulting electrically conductive paste was subjected to screen printing, dried and evaluated. Physical properties of the resulting coat were as follows: the specific resistance was 2.4 × 10⁻² Ω.cm, the adhesive property was good and the pencil hardness was H. In addition, the lattice-shaped printed product prepared in the above (5) was molded by a vacuum molding machine and its ductility (moldability) was evaluated. The result is shown in Table 1 and Table 2.

### <Examples 2-10> and <Comparative Examples 1-4>

Hereinafter, electrically conductive pastes for molding processing were prepared using materials shown in Table 1 and Table 2 in a manner similar to Example 1 and each of them was evaluated. The result is shown in Table 1 and Table 2.

In any of Examples, the physical properties of coat and the environmental test were good. Good result was also obtained in the stability upon storage and in the printing property. On the contrary, in Comparative Examples 1 and 2 which use spherical silver or flaky silver, the disconnection happened after molding. In Comparative Example 3 which uses both of spherical silver and aggregated silver particles, the disconnection happened after molding. In Comparative Example 4 which uses a resin having the glass transition temperature of 95°C, the disconnection happened after molding.

As to resin, electrically conductive powder, curing agent, catalyst and solvent mentioned in the Tables, the followings were used.
Resin 1: Copolymerized polyester BX 1001 manufactured by Toyobo (number-average molecular weight = 30000, Tg = -16°C)
Resin 2: Copolymerized polyester RV 600 manufactured by Toyobo (number-average molecular weight = 16000, Tg = 45°C)
Resin 3: Copolymerized polyurethane UR3210 manufactured by Toyobo (number-average molecular weight = 33000, Tg = -3°C)
Resin 4: Copolymerized polyester RV 345 manufactured by Toyobo (number-average molecular weight = 28000, Tg = 10°C)
Resin 5: Copolymerized polyester GK 880 manufactured by Toyobo (number-average molecular weight = 18000, Tg = 88°C)
Curing agent 1: E 402 manufactured by Asahi Kasei Chemicals
Curing agent 2: BI-7960 manufactured by Baxenden
Curing catalyst: KS 1260 manufactured by Kyodo Yakuhin
Silver powder 1: Aggregated silver particle powder (tap density: 2.5 g/cm³; specific surface area: 0.8 m²/g; average particle diameter: 0.8 µm)
Silver powder 2: Aggregated silver particle powder (tap density: 3.0 g/cm³; specific surface area: 1.6 m²/g; average particle diameter: 1.5 µm)
Silver powder 3: Aggregated silver particle powder (tap density: 2.1 g/cm³; specific surface area: 1.1 m²/g; average particle diameter: 1.0 µm)
Silver powder 4: Aggregated silver particle powder (tap density: 3.2 g/cm³; specific surface area: 1.6 m²/g; average particle diameter: 1.3 µm)
Silver powder 5: Aggregated silver particle powder (tap density: 4.3 g/cm³; specific surface area: 0.8 m²/g; average particle diameter: 1.3 µm)
Silver powder 6: Spherical silver powder (tap density: 5.3 g/cm³; specific surface area: 0.9 m²/g; average particle diameter: 0.6 µm)
Silver powder 7: Flaky silver powder (tap density: 4.4 g/cm³; specific surface area: 0.9 m²/g; average particle diameter: 2.4 µm)
Carbon black: Ketjen ECP600JD manufactured by Lion
Solvent 1: ECA - Ethyl carbitol acetate manufactured by Daicel
Solvent 2: DPM - Dipropylene glycol monomethyl ether manufactured by Toho Kagaku Kogyo

**[Table 1]**

| | | | Example 1 | Example 2 | Example 3 | Example 4 | Example 5 | Example 6 | Example 7 |
|---|---|---|---|---|---|---|---|---|---|
| Composition ratio (parts by mass) | Resin | Resin 1 | 112 | 112 | 112 | 136 | 112 | - | - |
| | | Resin 2 | - | - | - | - | - | 112 | - |
| | | Resin 3 | - | - | - | - | - | - | 112 |
| | | Resin 4 | - | - | - | - | - | - | - |
| | | Resin 5 | - | - | - | - | - | - | - |
| | Curing agent | Curing agent 1 | 8 | 8 | 8 | 9 | 8 | - | - |
| | | Curing agent 2 | - | - | - | - | - | 8 | 8 |
| | Curing catalyst | Catalyst | 3 | 3 | 3 | 4 | 3 | 3 | 3 |
| | Electrically conductive powder | Silver powder 1 | 697 | - | - | - | - | 697 | 697 |
| | | Silver powder 2 | - | 697 | - | - | - | - | - |
| | | Silver powder 3 | - | - | 697 | - | - | - | - |
| | | Silver powder 4 | - | - | - | 634 | - | - | - |
| | | Silver powder 5 | - | - | - | - | 697 | - | - |
| | | Silver powder 6 | - | - | - | - | - | - | - |
| | | Silver powder 7 | - | - | - | - | - | - | - |
| | | Carbon black | 6 | 6 | 6 | 6 | 6 | 6 | 6 |
| | Additive | Dispersing agent 1 | 5 | 5 | 5 | - | 5 | 5 | 5 |
| | | Dispersing agent 2 | - | - | - | 6 | - | - | - |
| | Solvent | ECA | 169 | 169 | 169 | 205 | 169 | 169 | 169 |
| | | DPM | - | - | - | - | - | - | - |
| | Total | | 1000 | 1000 | 1000 | 1000 | 1000 | 1000 | 1000 |
| Specific resistance | | Ω·cm | 2.4×10⁻² | 1.1×10⁻⁴ | 1.6×10⁻⁴ | 4.5×10⁻⁴ | 8.0×10⁻² | 3.2×10⁻¹ | 7.8×10⁻⁴ |
| Moldability (Ductility) | | | ○○ | Δ | Δ | ○ | Δ | ○○ | ○○ |
| Adhesive property | | | ○○ | ○○ | ○○ | ○○ | ○○ | ○○ | ○○ |
| Pencil hardness | | | H | H | H | H | H | H | H |
| Stability upon storage | | | ○○ | ○○ | ○○ | ○○ | ○○ | ○○ | ○○ |

**[Table 2]**

| | | | Example 8 | Example 9 | Example 10 | Comparative Example 1 | Comparative Example 2 | Comparative Example 3 | Comparative Example 4 |
|---|---|---|---|---|---|---|---|---|---|
| Composition ratio (parts by mass) | Resin | Resin 1 | - | 125 | 136 | 112 | 112 | 112 | - |
| | | Resin 2 | - | - | - | - | - | - | - |
| | | Resin 3 | - | - | - | - | - | - | - |
| | | Resin 4 | 112 | - | - | - | - | - | - |
| | | Resin 5 | - | - | - | - | - | - | 112 |
| | Curing agent | Curing agent 1 | - | 8 | 9 | 8 | 8 | 8 | 8 |
| | | Curing agent 2 | 8 | - | - | - | - | - | - |
| | Curing catalyst | Catalyst | 3 | 4 | 4 | 3 | 3 | 3 | 3 |
| | Electrically conductive powder | Silver powder 1 | 697 | - | - | - | - | 487.9 | 697 |
| | | Silver powder 2 | - | 663 | 634 | - | - | - | - |
| | | Silver powder 3 | - | - | - | - | - | - | - |
| | | Silver powder 4 | - | - | - | - | - | - | - |
| | | Silver powder 5 | - | - | - | - | - | - | - |
| | | Silver powder 6 | - | - | - | - | 697 | 209.1 | - |
| | | Silver powder 7 | - | - | - | 697 | - | - | - |
| | | Carbon black | 6 | 6 | 6 | 6 | 6 | 6 | 6 |
| | Additive | Dispersing agent 1 | 5 | - | - | 5 | 5 | 5 | 5 |
| | | Dispersing agent 2 | - | 6 | 6 | - | - | - | - |
| | Solvent | ECA | 169 | 188 | 205 | 169 | 169 | 169 | - |
| | | DPM | - | - | - | - | - | - | 169 |
| | Total | | 1000 | 1000 | 1000 | 1000 | 1000 | 1000 | 1000 |
| Specific resistance | | Ω·cm | 5.5×10⁻⁴ | 1.7×10⁻⁴ | 4.2×10⁻⁴ | 8.0×10⁻⁵ | 5.6×10⁻⁵ | 7.5×10⁻³ | 7.5×10⁻³ |
| Moldability (Ductility) | | | ○ | ○○ | ○○ | × | × | × | × |
| Adhesive property | | | ○○ | ○○ | ○○ | ○○ | ○○ | ○○ | ○○ |
| Pencil hardness | | | H | H | H | H | H | H | 2H |
| Stability upon storage | | | ○○ | ○○ | ○○ | ○○ | ○○ | ○○ | ○ |

### <Application Example 1>

A predetermined circuit pattern was printed by screen printing on an amorphous PET sheet in 200 µm thickness using the electrically conductive paste for molding processing manufactured in Example 1. In the circuit pattern, the minimum line width was 120 µm, the minimum line interval was 80 µm and the trunk thickness was 23 µm. The resulting printed product was thermally deformed using a predetermined mold having a spherical extruding part subjected to a releasing treatment whereupon a circuit substrate plate having a three-dimensional shape was prepared. The maximum deforming rate was set to be 150%. The resulting three-dimensional circuit did not have any disconnection and showed good electrical conductivity characteristics.

### <Application Example 2>

A touch panel pattern in the minimum line width of 50 µm was subjected to a gravure printing on a polycarbonate film of 75 µm thickness using the electrically conductive paste for molding processing prepared in Example 6. The resulting printed product was thermally deformed, and molded in such a direction wherein the wiring parts positioned on both sides of touch panel display were folded to back side. The maximum deforming rate was 60%. After that, predetermined parts were installed therein to give a touch panel having a three-dimensional shape. A touch side of the resulting touch panel did not have any winkle and showed a good surface appearance. Also, the disconnection of the electrically conductive paste part was not observed as well.

### Industrial Applicability

The electrically conductive paste used in the present invention can prevent the disconnection by thermal stretch upon molding and is suitable for forming a touch sensor for molding processing.

## Claims

1. A three-dimensional printed circuit having a wire formed from an electrically conductive paste for molding processing which contains aggregated silver particles, a resin having glass transition temperature of 45°C or lower, a curing agent and a solvent,
wherein the aggregated silver particles are silver particles consisting of primary particles having an average particle diameter of 0.1 to 3 µm that are aggregated in a three-dimensional manner, and wherein the average particle diameter of the primary particles is a number-average particle diameter measured by an enlarged observation under a scanning electron microscope, and
wherein tap density of the aggregated silver particles is 2 to 5 g/cm³,
wherein the glass transition temperature is determined according to the measurement method disclosed in the description.

2. The three-dimensional printed circuit according to claim 1, wherein specific surface area of the aggregated silver particles is 0.5 to 2.0 m²/g.

3. The three-dimensional printed circuit according to claim 1 or 2, wherein number-average molecular weight of the resin is 5000 to 40000,
wherein the number-average molecular weight is determined according to the measurement method disclosed in the description.

4. The three-dimensional printed circuit according to any of claims 1 to 3, wherein the paste contains carbon black as an electrically conductive filler.

5. A method for producing the three-dimensional printed circuit according to any of claims 1 to 4, wherein the electrically conductive paste for molding processing is printed on a thermoplastic substrate and is subjected to thermal deformation.

6. A touch sensor having a wire formed from an electrically conductive paste for molding processing which contains aggregated silver particles, a resin having glass transition temperature of 45°C or lower, a curing agent and a solvent,
wherein the aggregated silver particles are silver particles consisting of primary particles having an average particle diameter of 0.1 to 3 µm that are aggregated in a three-dimensional manner, and wherein the average particle diameter of the primary particles is a number-average particle diameter measured by an enlarged observation under a scanning electron microscope, and
wherein tap density of the aggregated silver particles is 2 to 5 g/cm³,
wherein the glass transition temperature is determined according to the measurement method disclosed in the description.

7. The touch sensor according to claim 6, wherein specific surface area of the aggregated silver particles is 0.5 to 2.0 m²/g.

8. The touch sensor according to claim 6 or 7, wherein number-average molecular weight of the resin is 5000 to 40000,
wherein the number-average molecular weight is determined according to the measurement method disclosed in the description.

9. The touch sensor according to any of claims 6 to 8, wherein the paste contains carbon black as an electrically conductive filler.

10. A method for producing the touch sensor having a nonplanar structure according to any of claims 6 to 9, wherein the electrically conductive paste for molding processing is printed on a transparent thermoplastic substrate and is subjected to thermal deformation.

## Patentansprüche

1. Dreidimensionale gedruckte Schaltung mit einem Draht, der aus einer elektrisch leitfähigen Paste zur Formverarbeitung gebildet ist, die aggregierte Silberteilchen, ein Harz mit einer Glasübergangstemperatur von 45°C oder niedriger, ein Härtungsmittel und ein Lösungsmittel enthält,
wobei die aggregierten Silberteilchen Silberteilchen sind, die aus Primärteilchen mit einem durchschnittlichen Teilchendurchmesser von 0,1 bis 3 µm bestehen, die in einer dreidimensionalen Weise aggregiert sind, und wobei der durchschnittliche Teilchendurchmesser der Primärteilchen ein zahlenmittlerer Teilchendurchmesser ist, der durch eine vergrößerte Beobachtung unter einem Rasterelektronenmikroskop gemessen wird, und
wobei die Klopfdichte der aggregierten Silberteilchen 2 bis 5 g/cm³ beträgt,
wobei die Glasübergangstemperatur gemäß dem in der Beschreibung offengelegten Messverfahren bestimmt wird.

2. Dreidimensionale gedruckte Schaltung nach Anspruch 1, wobei die spezifische Oberfläche der aggregierten Silberpartikel 0,5 bis 2,0 m²/g beträgt.

3. Dreidimensionale gedruckte Schaltung nach Anspruch 1 oder 2, wobei das zahlengemittelte Molekulargewicht des Harzes 5000 bis 40000 beträgt,
wobei das zahlengemittelte Molekulargewicht gemäß dem in der Beschreibung offenbarten Messverfahren bestimmt wird.

4. Dreidimensionale gedruckte Schaltung nach einem der Ansprüche 1 bis 3, wobei die Paste Ruß als einen elektrisch leitenden Füllstoff enthält.

5. Verfahren zur Herstellung einer dreidimensionalen gedruckten Schaltung nach einem der Ansprüche 1 bis 4, wobei die elektrisch leitfähige Paste für die Formgebung auf ein thermoplastisches Substrat gedruckt und thermisch verformt wird.

6. Berührungssensor mit einem Draht, der aus einer elektrisch leitfähigen Paste für die Formverarbeitung gebildet ist, die aggregierte Silberteilchen, ein Harz mit einer Glasübergangstemperatur von 45°C oder niedriger, ein Härtungsmittel und ein Lösungsmittel enthält,
wobei die aggregierten Silberteilchen Silberteilchen sind, die aus Primärteilchen mit einem durchschnittlichen Teilchendurchmesser von 0,1 bis 3 µm bestehen, die in einer dreidimensionalen Weise aggregiert sind, und wobei der durchschnittliche Teilchendurchmesser der Primärteilchen ein zahlenmittlerer Teilchendurchmesser ist, der durch eine vergrößerte Beobachtung unter einem Rasterelektronenmikroskop gemessen wird, und
wobei die Klopfdichte der aggregierten Silberteilchen 2 bis 5 g/cm³ beträgt,
wobei die Glasübergangstemperatur gemäß dem in der Beschreibung offenbarten Messverfahren bestimmt wird.

7. Berührungssensor nach Anspruch 6, wobei die spezifische Oberfläche der aggregierten Silberpartikel 0,5 bis 2,0 m²/g beträgt.

8. Berührungssensor nach Anspruch 6 oder 7, wobei das zahlengemittelte Molekulargewicht des Harzes 5000 bis 40000 beträgt,
wobei das zahlengemittelte Molekulargewicht gemäß dem in der Beschreibung offenbarten Messverfahren bestimmt wird.

9. Berührungssensor nach einem der Ansprüche 6 bis 8, wobei die Paste Ruß als einen elektrisch leitenden Füllstoff enthält.

10. Verfahren zur Herstellung des Berührungssensors mit nicht-planarer Struktur nach einem der Ansprüche 6 bis 9, wobei die elektrisch leitfähige Paste zur Formgebung auf ein transparentes thermoplastisches Substrat gedruckt und thermisch verformt wird.

## Revendications

1. Circuit imprimé tridimensionnel ayant un fil métallique formé d'une pâte électriquement conductrice pour un traitement de moulage qui contient des particules d'argent agrégées, une résine ayant une température de transition vitreuse de 45 °C ou inférieure, un agent durcissant et un solvant,
dans lequel les particules d'argent agrégées sont des particules d'argent constituées de particules primaires ayant un diamètre particulaire moyen de 0,1 à 3 µm qui sont agrégées de manière tridimensionnelle, et dans lequel le diamètre particulaire moyen des particules primaires est un diamètre particulaire moyen en nombre mesuré par une observation grossie sous un microscope électronique à balayage, et
dans lequel une masse volumique après tassement des particules d'argent agrégées est de 2 à 5 g/cm³,
dans lequel la température de transition vitreuse est déterminée conformément au procédé de mesure divulgué dans la description.

2. Circuit imprimé tridimensionnel selon la revendication 1, dans lequel une surface spécifique des particules d'argent agrégées est de 0,5 à 2,0 m²/g.

3. Circuit imprimé tridimensionnel selon la revendication 1 ou 2, dans lequel un poids moléculaire moyen en nombre de la résine est de 5000 à 40 000,
dans lequel le poids moléculaire moyen en nombre est déterminé conformément au procédé de mesure divulgué dans la description.

4. Circuit imprimé tridimensionnel selon l'une quelconque des revendications 1 à 3, dans lequel la pâte contient du noir de carbone en tant que charge électriquement conductrice.

5. Procédé de production du circuit imprimé tridimensionnel selon l'une quelconque des revendications 1 à 4, dans lequel la pâte électriquement conductrice pour traitement de moulage est imprimée sur un substrat thermoplastique et est soumise à une déformation thermique.

6. Capteur tactile ayant un fil métallique formé d'une pâte électriquement conductrice pour un traitement de moulage qui contient des particules d'argent agrégées, une résine ayant une température de transition vitreuse de 45 °C ou inférieure, un agent durcissant et un solvant,
dans lequel les particules d'argent agrégées sont des particules d'argent constituées de particules primaires ayant un diamètre particulaire moyen de 0,1 à 3 µm qui sont agrégées de manière tridimensionnelle, et dans lequel le diamètre particulaire moyen des particules primaires est un diamètre particulaire moyen en nombre mesuré par une observation grossie sous un microscope électronique à balayage, et
dans lequel une masse volumique après tassement des particules d'argent agrégées est de 2 à 5 g/cm³,
dans lequel la température de transition vitreuse est déterminée conformément au procédé de mesure divulgué dans la description.

7. Capteur tactile selon la revendication 6, dans lequel une surface spécifique des particules d'argent agrégées est de 0,5 à 2,0 m²/g.

8. Capteur tactile selon la revendication 6 ou 7, dans lequel un poids moléculaire moyen en nombre de la résine est de 5000 à 40 000,
dans lequel le poids moléculaire moyen en nombre est déterminé conformément au procédé de mesure divulgué dans la description.

9. Capteur tactile selon l'une quelconque des revendications 6 à 8, dans lequel la pâte contient du noir de carbone en tant que charge électriquement conductrice.

10. Procédé de production du capteur tactile ayant une structure non plane selon l'une quelconque des revendications 6 à 9, dans lequel la pâte électriquement conductrice pour traitement de moulage est imprimée sur un substrat thermoplastique transparent et est soumise à une déformation thermique.
